(19) Europäisches Patentamt
European Patent Office
Office européen des brevets

(11) **EP 1 994 384 B1**

(12) **EUROPÄISCHE PATENTSCHRIFT**

(45) Veröffentlichungstag und Bekanntmachung des Hinweises auf die Patenterteilung:
**27.01.2010 Patentblatt 2010/04**

(21) Anmeldenummer: **06707556.4**

(22) Anmeldetag: **14.03.2006**

(51) Int Cl.:
**G01J 5/20** (2006.01)     **H01L 51/42** (2006.01)

(86) Internationale Anmeldenummer:
**PCT/EP2006/002326**

(87) Internationale Veröffentlichungsnummer:
**WO 2007/104328 (20.09.2007 Gazette 2007/38)**

(54) **B0L0METER MIT ORGANISCHER HALBLEITERSCHICHTANORDNUNG**

BOLOMETER HAVING AN ORGANIC SEMICONDUCTOR LAYER ARRANGEMENT

BOLOMETRE MUNI D'UN AGENCEMENT A COUCHE DE SEMICONDUCTEUR ORGANIQUE

(84) Benannte Vertragsstaaten:
**DE FR**

(43) Veröffentlichungstag der Anmeldung:
**26.11.2008 Patentblatt 2008/48**

(73) Patentinhaber: **Fraunhofer-Gesellschaft zur Förderung der angewandten Forschung e.V.**
**80686 München (DE)**

(72) Erfinder: **VOGT, Holger**
**45481 Mülheim (DE)**

(74) Vertreter: **Zimmermann, Tankred Klaus et al**
**Schoppe, Zimmermann, Stöckeler & Zinkler**
**Patentanwälte**
**Postfach 246**
**82043 Pullach bei München (DE)**

(56) Entgegenhaltungen:
- PFEIFFER M ET AL: "Controlled p-doping of pigment layers by cosublimation: Basic mechanisms and implications for their use in organic photovoltaic cells" SOLAR ENERGY MATERIALS AND SOLAR CELLS, ELSEVIER SCIENCE PUBLISHERS, AMSTERDAM, NL, Bd. 63, Nr. 1, Juni 2000 (2000-06), Seiten 83-99, XP004201249 ISSN: 0927-0248
- NEUZIL P ET AL: "MICROMACHINED BOLOMETER WITH SINGLE-CRYSTAL SILICON DIODE AS TEMPERATURE SENSOR" IEEE ELECTRON DEVICE LETTERS, IEEE SERVICE CENTER, NEW YORK, NY, US, Bd. 26, Nr. 5, Mai 2005 (2005-05), Seiten 320-322, XP001227528 ISSN: 0741-3106 in der Anmeldung erwähnt

**Beschreibung**

Die vorliegende Erfindung bezieht sich auf Bolometer.

Ein Bolometer ist ein Gerät zum Messen elektromagnetischer Strahlung einer bestimmten Frequenz. Es umfasst einen Absorber, der die elektromagnetische Strahlung in Wärme umwandelt, und ein Thermometer. In Abhängigkeit von einer Wärmekapazität des Materials besteht ein direkter Zusammenhang zwischen einer Menge an absorbierter Strahlung und einer resultierenden Temperaturerhöhung. Damit kann die Temperatur als ein Maß für eine Intensität der eingefallenen Strahlung dienen. Besonders interessant sind Bolometer zum Messen einer Infrarotstrahlung, wo die meisten Bolometer eine höchste Sensitivität aufweisen.

Ein Bolometer kann in der Technik als Infrarotsensor, bildaufnehmer für ein Nachtsichtgerät, als Infrarotkamera oder als Wärmebildkamera verwandt werden. Dabei können Bolometer als Einzelsensor eingesetzt werden oder zu einer Sensorzeile bzw. zu einem 2-dimensionalen Array (Mikrobolometer-Array) kombiniert werden.

Im Sensor ist eine dünne Schicht thermisch isoliert angeordnet, z.B. als eine Membran aufgehängt. Die Infrarotstrahlung wird in dieser Membran absorbiert, die dadurch ihre Temperatur erhöht. Besteht diese Membran aus einem Material mit endlichem elektrischen Widerstand verändert sich dieser elektrische Widerstand in Abhängigkeit von der Temperaturerhöhung und einem Temperaturkoeffizienten des Widerstands. Weitere Details werden in dem folgenden Dokument beschrieben: http://www-leti.cea.fr/commun/AR-1403/T5-Photodetection/25-J-Ltissot.pdf . Alternativ ist die Membran ein Isolator (Siliziumoxid oder Siliziumnitrid), auf der der Widerstand als weitere dünne Schicht abgeschieden wurde. In anderen Ausführungen sind zusätzlich zur Widerstandsschicht Isolationsschichten und eine Absorberschicht angebracht.

Für die Sensitivität des Bolometers ist es wichtig, dass sich der elektrische Widerstand schnell und signifikant mit der Temperatur ändert. Die Temperaturabhängigkeit von Metallschichtwiderständen ist linear. Halbleiter als Widerstandsmaterial haben eine exponentielle Abhängigkeit. Eine ebenso hohe Abhängigkeit versprechen Dioden als Wärmedetektoren mit ihrer Strom-Spannungskennlinie nach:

$$I_D = I_0 \cdot \left( Exp\{eU_D / kT\} - 1 \right)$$

wobei $T$ die Temperatur, $k$ die Boltzmann Konstante, $e$ die elektrische Ladung, $I_D$ und $U_D$ eine Stromstärke und Spannung in der Diode bezeichnet sowie $I_0$ eine Spannungsunabhängige Konstante ist.

Bolometer, die als Zeilen oder Arrays angeordnet sind, werden heute typisch mit Verfahren der Mikrosystemtechnik in Oberflächenmikromechanik auf Siliziumsubstraten hergestellt. Hier spricht man von Mikrobolometer-Arrays.

Eine bevorzugte Wellenlänge der zu detektierenden Infrarotstrahlung liegt bei 8 - 14 μm, da in diesem Wellenlängenbereich Festkörper strahlen, die in etwa Raumtemperatur (300 K) haben. Der Wellenlängenbereich von 3 - 5 μm ist ebenfalls interessant wegen des durchlässigen atmosphärischen Fensters.

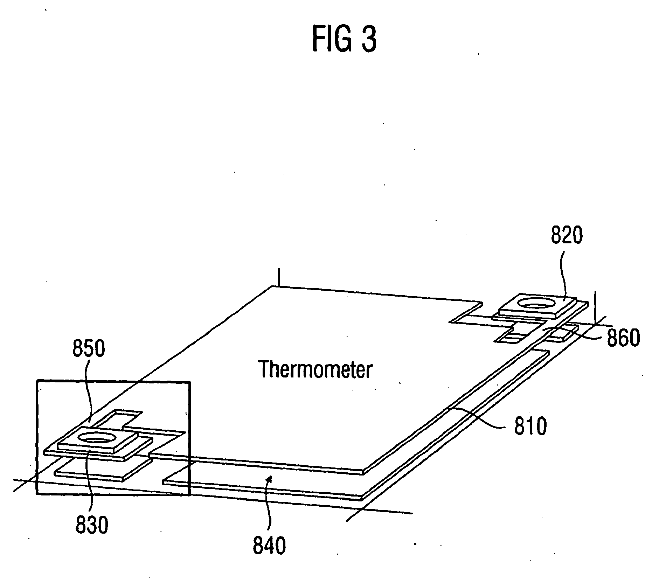

Fig. 3 zeigt beispielhaft ein Bolometer. Es umfasst eine Thermometerschicht aus amorphen Silizium, die als Membran zwischen zwei Abstandshaltern 820 und 830 an deren Ecken aufgespannt ist. Unterhalb dieser Membran befindet sich in einem Abstand von ungefähr 2,5 μm eine Reflektorschicht 840. Die Thermometerschicht bzw. Membran hat eine Dicke von ungefähr 0,1 μm. Die Abstandshalter 820 und 830 fixieren nicht nur die Membran 810 über der Reflektorschicht 840 an gegenüberliegenden Seiten, sondern sie stellen auch einen elektrischen Kontakt zwischen dem jeweiligen Ende der Thermometerschicht 810 und einer darunter liegenden Schaltung (nicht gezeigt) her, wie z.B. über eine Metall-Anschlussfläche zu einer integrierten Ausleseschaltung ROIC (ROIC = readout integrated circuit). Um eine möglichst hohe thermische Sensibilität zu erreichen, ist die Thermometerschicht 810 an den aufgehängten Enden so geformt, dass sie über schmale Abschnitte 850 und 860 mit den Abstandshaltern verbunden ist, so dass eine thermische Isolation der Thermometerschicht 810 erzielt werden kann.

Ein wesentlicher Vorteil der thermischen Bolometer gegenüber anderen (photonischen) Infrarotdetektoren ist, dass sie bei Raumtemperatur, d.h. ungekühlt betrieben werden können.

Gute Dioden, die auf anorganischen Halbleitermaterialien beruhen, lassen sich bisher nur in einkristallinem Silizium, nicht aber in amorphem Silizium oder anderen bisher im Bolometer eingesetzten Halbleitermaterialien (VanadiumOxid; amorphes oder polykristallines Si, Ge oder SiGe) herstellen. Die Verwendung einkristallinem Siliziums auf einer thermisch isolierten Membran ist z.B. durch eine Silizumauf-Isolator-Technik oder durch Unterätzen von Dioden im Siliziumsubstrat, möglich. Diese Techniken sind beschrieben in: T. Ishikawa e.a.: "Performance of 320 x 320 Uncooled IRFPA with SOI Diode Detectors", Proc. SPIE, vol. 4130, pp. 152 - 159, (1400) bzw. in: P. Neuzil, Y. Liu, H.-F. Feng, and W. Zeng: "Micromachined Bolometer with Single-Crystal Silicon Diode as Temperature Sensor", IEEE Electron.Dev.Letters, vol. 26, no.5, May 2005, pp. 320-322.

Nachteile der bestehenden Technik sind z.B., dass beim Verwenden von anorganischen Halbleitermaterialien aktive (CMOS-) Ansteuer- und Verstärkerelemente nicht unterhalb der Sensorstruktur integriert werden können. Die vielleicht mögliche Mitintegration dieser Elemente neben dem Detektor führt zu einer starken Reduktion des Füllfaktors (Detektorfläche zur Gesamtfläche) und erhöht dadurch die Chipfläche und die Detektorkosten. Zudem ist es nicht möglich, mit diesen Strukturen einen Absorber herzustellen, der eine Widerstandsschicht in Höhe des Ausbreitungswiderstands einer elektromagnetischen Welle in Luft hat (377 $\Omega/\square$) und in einem Abstand von $\lambda/4$ (von ca. 2,5 $\mu$m, bei einer Wellenlänge von 10 $\mu$m) über einen Reflektor angeordnet ist. In der Arbeit: J.-J.Brissot, F. Desvignes, and R. Martres : "Organic Semiconductor Bolometric Target for Infrared Imaging Tubes", IEEE Trans. Electron. Dev., vol. 20, no. 7, July 1973, pp. 613-620, (1973), wird ein Bolometertarget aus einem undotierten organischen Halbleiter als temperaturabhängiger Widerstand in einem Infrarot-Vidikon genutzt.

Die Verwendung undotierter organischer Halbleiterschichten, wie sie in der soeben zitierten Arbeit verwendet werden, hat wiederum den Nachteil, dass diese Schicht sehr hochohmig ($10^{14}$ $\Omega$cm bei 70°C) ist und beide Seiten großflächig kontaktiert werden müssen.

Die Aufgabe der vorliegenden Erfindung besteht darin, ein Bolometer zu schaffen, dass eine hohe Empfindlichkeit bei gleichzeitiger Möglichkeit eine Mitintegration einer Auswerte- bzw. Messschaltung mit geringeren Kosten bzw. Aufwand zulässt.

Diese Aufgabe wird durch ein Bolometer gemäß Anspruch 1 gelöst.

Ein Bolometer gemäß der vorliegenden Erfindung enthält eine organische Halbleiterdiodenschichtanordnung zur Messung der Temperatur. Diese Dioden können großflächig sein, wie z.B. mehrere mm² groß, weshalb eine hohe Ausbeute auch bei kleinen Array-Pixeln mit einer Membranfläche von ca. 25x25 $\mu$m² erreichbar ist. Ferner lassen sich gute Dioden mit ideal geformter Kennlinie, d.h. mit einem großer Bereich exponentiellen Stromanstiegs, herstellen, wie es im Zusammenhang mit organischen Leuchtdioden (OLED) beispielsweise bereits realisiert worden ist.

Ein erfindungsgemäßes Bolometer hat also einen Vorteil, in der Strom-Spannungskennlinie einen großen Bereich mit exponentieller Temperaturabhängigkeit aufzuweisen und trotzdem einen niedrigen elektrischen Widerstand zu besitzen. Im Weiteren ermöglicht es einen hohen Füllfaktor, wobei die Pixelgröße klein genug realisiert werden kann, um 2-dimensionale Arrays zu realisieren.

In den letzten Jahren konnten organischen Halbleiter in einer Qualität hergestellt werden, die ihren Einsatz in der Mikroelektronik und Mirkosystemtechnik erlauben. Untersuchte Einsatzgebiete sind "Plastiktransistoren", d.h. integrierte Schaltungen in organischen Halbleitern, und insbesondere auch OLEDs. Die p-n-Übergänge in organischen Halbleitern werden bisher bevorzugt zum Erzeugen von Licht genutzt (optische LEDs, OLEDs). Die typische Durchlassspannung einer solchen Diode liegt oberhalb von 2 Volt. Die Herstellung dieser Dioden erfolgt großflächig als Mehrschichtsystem, wozu beispielsweise auf D. Gebeyehu, K. Walzer, G. He, M. Pfeiffer, K. Leo, J. Brandt, A. Gerhardt and H. Vestweber: "Highly efficient deep-blue organic light emitting diodes with dopsed transport layers", Synthetic Metals 148 (2), pp. 205-211 (2005) verwiesen wird. Es ist aber auch möglich, flächige Dioden mit einer Durchlassspannung von unter 1 Volt herzustellen, deren Strom-Spannungskennlinie sehr ähnlich der einer Siliziumdiode ist, wozu auf US Pat. 6,812,638 B2 verwiesen sei.

Die organischen Halbleiterdiodenschichten lassen sich aus kleinen Molekülen durch Aufdampfen öder aus Polymeren durch aufschleudern oder auch durch Druckverfahren ähnlich denen bei Tintenstrahldruckern, herstellen. Sie sind hochrein und lassen sich strukturieren, wozu auf M. Pfeiffer, S. R. Forrest: "Organic Light Emitting Diodes", in: R. Waser (Ed.), Nanoelectronics and Information Technology, Advanced Electronic Materials and Novel Devices, Wiley VCH (2003) und T. Kawase e.a.: "All-Polymer Thin Film Transistors Fabricated by High-Resolution Inkjet Printing", Proc. IEDM, 623-626 (2000) verwiesen wird. Inzwischen wurden auch bereits langzeitstabile OLEDs beschrieben, wie z.B. in P. Wellmann e.a.: "High-efficiency p-i-n organic light-emitting diodes with long lifetime", Journal of the SID 13/5, pp. 393-397 (2005). Insbesondere lässt sich der Widerstand von organischen Halbleiterdioden einstellen durch geeignete p- oder n-Dotierungen, in welcher Hinsicht auf M. Pfeiffer e.a.: "Doped organic semiconductors: Physics and application in light emitting diodes", Organic Electronics vol. 4, pp. 89-103 (2003) verwiesen wird. Über die Dotierung eines organischen Halbleiters kann eine drastische Reduktion von dessen Widerstand, z.B. von $10^{10}$ $\Omega$cm bei Pthalozyanin auf $10^3$ $\Omega$cm nach einer Dotierung mit 1% $F_4$-TCNQ (tetrafluorotetracynoquinodimethan) erzielt werden, wozu auf die zuletzt zitierte Arbeit verwiesen wird. Damit sind diese Schichten niederohmig kontaktierbar, z.B. mit ITO (ITO = indium-tin-oxid) oder mit Aluminium.

Erfindungsgemäß ist die p-dotierte Schicht elektrisch über eine Kontaktschicht mit einem Abstandshalter verbunden, und die n-dotierte Schicht ist über eine weitere Kontaktschicht elektrisch mit einem zweiten Abstandshalter verbunden. Die beiden Abstandshalter dienen als elektrische Anschlüsse und tragen die organische Halbleiterdiodenschicht, so dass sie über beispielsweise einem Reflektor in einem $\lambda/4$-Abstand schwebt. Gegebenenfalls kann der Kontakt zwischen Halbleiterschicht und Abstandshalter auch direkt bzw. unmittelbar erfolgen. Eine mögliche Schichtfolge ist beispielsweise Nitrid - untere Kontaktschicht - organische Halbleiterdiode - obere Kontaktschicht - organische Schutzschicht. Die organischen Träger und Schutzschichten bestehen z.B. aus Polyimid, Parylen oder BCB (Benzocyclobutene). Die organische Halbleiterschicht besteht z.B. aus p- und n-dotiertem Pentazen, Anthrazen, Pthalozyanin oder Bathophenanthrolin, gegebenenfalls mit einer undotierten Zwischenschicht.

Diese Schichtfolge wird vorzugsweise mit Hilfe der Abstandshalter in einem fixierten Abstand über dem Substrat, auf dem sich ein Reflektor befinden kann, gehalten. Im Idealfall bilden die Halbleiterschichtanordnung und der Reflektor einen λ/4-absorber. Das ist der Fall, wenn der Abstand zwischen der Schichtfolge und dem Reflektor gerade ein Viertel der Wellenlänge der interferierenden bzw. erfassten IR-Strahlung beträgt, wobei der elektrische Widerstand der Halbleiterschichtanordnung vorzugsweise dem Ausbreitungswiderstand einer elektromagnetischen Welle in Luft entspricht.

In einem weiteren Ausführungsbeispiel umfasst die Schichtfolge die folgenden 7 Schichten: einen ITO-Kontakt, eine p-dotierte Löchertransportschicht, eine Elektronensperrschicht, eine Emissionsschicht, eine Löchersperrschicht, eine n-dotierte Elektronentransportschicht und eine Kontaktschicht aus Aluminium.

Im Vergleich zu bekannten Diodenstrukturen aus Silizium, besitzen organische Dioden eine Reihe von Vorteilen. Da sie bisher vornehmlich auf große Flächen für die Lichtemission entwickelt wurden, darf mit einer guten Ausbeute auch bei der Verwendung in einem Bolometer-Array mit kleinen Pixeln gerechnet werden. Die thermische Leitfähigkeit und Wärmekapazität organischer Schichten ist typischerweise kleiner als die von Halbleitern und Metallen, so dass eine bessere thermische Isolation erzielbar ist. Wie alle Dioden besitzen sie eine exponentielle Abhängigkeit der Strom-Spannungscharakteristik von der Temperatur und zeigen deshalb im Vergleich zu Metall-basierten Widerstandsschichten eine hohe Temperaturabhängigkeit des differentiellen Widerstands.

Die Langzeitstabilität der organischen Schicht wird besser sein als bei OLEDs, da wegen der thermischen Isolation die Sensoren zumeist ohnehin in einem evakuierten Gehäuse aufgebaut werden. Damit wird eine Degradation durch Sauerstoff oder Feuchtigkeit vermieden. Außerdem lässt sich unterhalb der Diodenmembran die Pixelelektronik beispielsweise im Si-, liziumsubstrat integrieren, da die Niedertemperaturabscheidung der organischen Halbleiterschichten, die beispielsweise als CMOS-Elektronik aufgebaut ist, nicht beeinflusst. Dadurch unterscheiden sich organische Halbleiterdioden von bekannten Diodenstrukturen aus Silizium, die nur schwer in einem Substrat mit bereits integrierter Elektronik zu integrieren sind, also keinen geeigneten Platz für die Integration der Schaltung unterhalb der Sensorschicht boten.

Bevorzugte Ausführungsbeispiele der vorliegenden Erfindung werden nachfolgend Bezug nehmend auf die beiliegenden Zeichnungen näher erläutert. Es zeigen:

Fig. 1 eine Querschnittsansicht eines Bolometers gemäß einem Ausführungsbeispiel der vorliegenden Erfindung;

Fig. 2. einen Querschnitt eines weiteren Ausführungsbeispieles, bei dem die Schichtfolge modifiziert wurden; und

Fig. 3 eine Raumsicht einer herkömmlichen Membran mit amorphem Silizium.

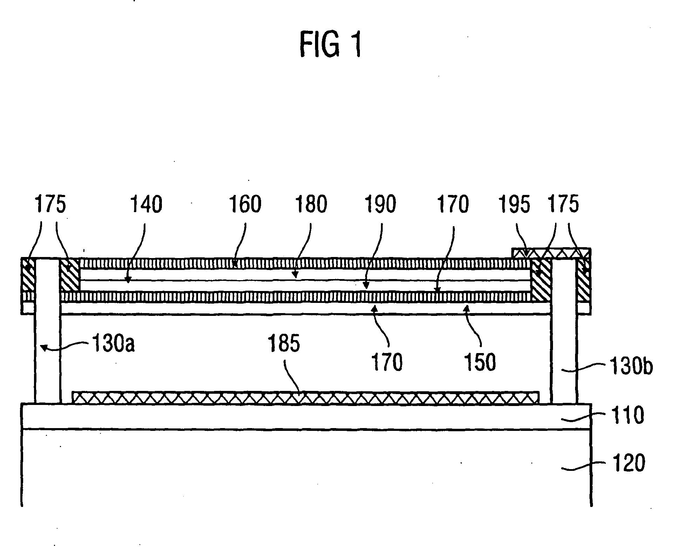

Dem nachfolgend beschriebenen Ausführungsbeispiel von Fig. 1 nach wird gegenüber dem Aufbau von Fig. 3 die Membran ersetzt durch eine Schichtanordnung aus Siliziumnitrid und/oder Siliziumoxid als nichtleitendem Träger, auf dem eine p-n- oder p-i-n-Diode als Mehrschichtsystem aus organischen Halbleiterschichten angeordnet ist.

Bei dem Bolometer von Fig. 1 ist ein planarer nichtleitender Untergrund 110, z.B. eine Schicht aus Siliziumoxid, auf einem Substrat, wie z.B. einer Siliziumscheibe 120, vorgesehen. Bei der Schicht 110 kann es sich beispielsweise um die polierte oberste Oxidschicht auf einem CMOS-Wafer handeln, der sämtliche Schichten und Strukturen enthält, die für eine CMOS-Schaltung unter der Oberfläche notwendig sind, wobei die CMOS-Schaltung beispielsweise eine Auswerteelektronik des Bolometers bildet.

Zwei Abstandshalter 130 stehen von dem nichtleitenden Untergrund 110 vor und tragen an ihrem dem Substrat 120 abgewandten Enden eine Membran 140. Die Membran 140 befindet sich somit freitragend über dem Untergrund 110, in dem sie zwischen den beiden Abstandshaltern 130 aufgehängt ist. Die Abstandshalter 130 dienten aber nicht nur der Halterung der Membran 140 sondern auch als elektrische Anschlüsse für eine in der Membran gebildeten organischen Diode, wie z.B. zum Anschluss an die vorher erwähnte Auswerteschaltung, die sich als CMOS-Schaltung beispielsweise unterhalb der Membran 140 befinden kann, weshalb die Abstandshalter im folgenden auch als Kontaktstöpsel bezeichnet werden. Sie können beispielsweise aus CVD-Wolfram (CVD = chemical vapour deposition) gebildet sein. Die Kontaktstöpsel verleihen der Membran den mechanischen Halt, indem sie eine in der Membran 140 vorgesehene Nitridschicht 150 mit einer Dicke von beispielsweise 100 bis 300 nm durchstoßen und halten. Letztere dient zur thermischen Isolation und ist Träger von kontaktschichten 160, 170 und organische Halbleiterschichten 180, 190, die ebenfalls Teil der Membran sind. Durch den Abstand zum Substrat 110 (ca. 0,5 bis 3 μm) wird die Membran 140 thermisch vom Substrat isoliert. Im einzelnen ist die Membran 140 aus der Nitridschicht 150 aufgebaut, auf der wiederum eine erste Kontaktschicht 170, wie z.B. aus ITO liegt, die einen flächigen Kontakt zu der folgenden p-leitenden organischen Halbleiterschicht 190 herstellt. Darauf ist wiederum die n-leitende Halbleiterschicht 180 angeordnet, worauf sich die zweite Kontaktschicht 160, die z.B. aus Al besteht, um die n-leitende organische Halbleiterschicht flächig zu kontaktieren, anschließt. Die organische Halbleiterschichten sind von beiden Abstandhaltern durch einen beispielsweise organischen Isolator 175 isoliert. Die untere Kontaktschicht 170 ist mit dem Abstandshalter 130a elektrisch verbunden und ein Kontaktmetall 195, das auf dem Stöpsel 130b und der Kontaktschicht 160 aufliegt, verbindet elektrisch die zweite Kontaktschicht 160 mit dem anderen Abstandshalter 130b.

Die Abstandshalter 130 können z.B., wie oben erwähnt, aus CVD-Wolfram bestehen und haben beispielsweise einen Durchmesser von ca. 1 μm. Mit ihnen wird die Membran 140 an zwei gegenüberliegenden Punkten elektrisch kontaktiert. Unten sind die Abstandshalter mit der vorher erwähnten Auswerteschaltung beispielsweise über Durchkontaktierungen durch die Schicht 110 verbunden.

In der Ausführung, die in Fig. 1 gezeigt ist, ist auf der Oxidoberfläche 110 eine Reflexionsschicht 185 aus Aluminium (ca. 140 nm dick) angeordnet. Im Idealfall bilden Membran und Reflektor einen Abstand, so dass ein λ/4-Absorber entsteht. Dazu hat die organische Halbleiterschicht der Membran einen elektrischen Widerstand von ca. 377 Ω/□ und liegt in einem Abstand von λ/4 (d.h. ca. 2,5 μm) oberhalb der Reflexionsschicht 185. Damit ist diese Anordnung ein Infrarotabsorber und der Schichtwiderstand entspricht dem Wellenwiderstand elektromagnetischer Strahlung in Luft. Somit wird das Infrarotsignal optimal absorbiert.

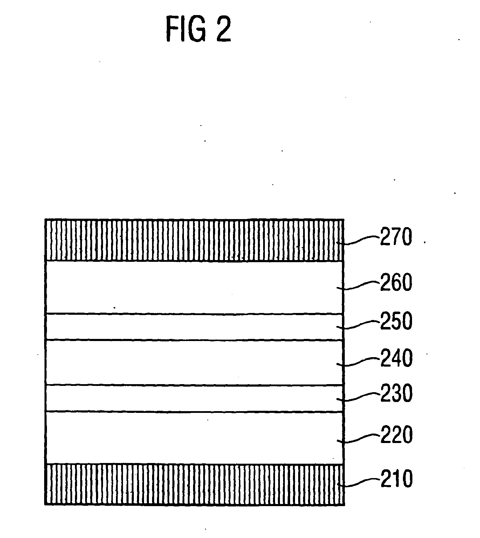

In Fig. 2 ist ein Querschnitt einer exemplarischen Schichtfolge für die Membran gezeigt, die einen organischen Halbleiter mit komplexerer Struktur besitzt. Gemäß Fig. 2 ist die Membran von untern nach oben aus folgenden 7 Schichten aufgebaut: ITO-Kontakt 210, p-dotierter Löchertransportschicht 220, Elektronensperrschicht 230, Emissionsschicht 240, Löchersperrschicht 250, n-dotierte Elektronentransportschicht 260 und Aluminium 270. Die ITO-Schicht 210 wäre mit dem Stöpsel 130a elektrisch verbunden, während die Al-Schicht 270 mit dem Stöpsel 130b elektrisch verbunden wäre, und die restlichen Schichten 220 - 260 wären durch das Isolationsmaterial 175 von dem Stöpsel 130a,b isoliert. Andere organische Diodenschichtfolgen können natürlich ebenfalls verwandt werden.

In weiteren Ausführungsbeispielen kann die Nitridschicht 150 beispielsweise durch eine Folge von Siliziumoxid und Siliziumnitridschichten ersetzt werden, oder die Membran 140 kann ausschließlich aus halbleitenden organischen Materialen bestehen. Bei geeigneter Stabilität eines .organischen Trägers ist auch folgende Schichtenfolge möglich: organischer Träger - organischer Halbleiter - organischer Schutzschicht. Auf dem Sensor in der Fig. 1 könnte außerdem eine zusätzliche Absorberschicht, wie z.B. aus Pt-Black, aufgebracht werden. Die Abstandshalter 130 können auch aus einem anderen Material bestehen, wie z.B. aus Aluminium oder aus einem hochdotierten Silizium.

Mit zunehmender Anwendung in Dünnfilmelektronik (z.B. bei TFTs) und der Optoelektronik (z.B. bei OLED) werden immer neue Materialkombinationen entstehen, die auch für den Einsatz in erfindungsgemäßen Bolometern geeignet sind. Die organische Chemie erlaubt eine nahezu unbegrenzte Kombinationsvielfalt.

Schließlich sollte auch erwähnt werden, dass die Aluminiumkontaktschicht 160 ganzflächig auf der Schicht 180 aufgebracht sein kann. Ein Aufbringen in Form einer Fingerstruktur kann aber vorteilhaft sein, um die Absorption zu verbessern. In letzterem Fall nimmt die Kontaktschicht 160 nur einen Teil der lateralen Fläche des Bolometers ein. Ähnliche Überlegungen gelten auch für die untere Kontaktschicht.

**Patentansprüche**

1. Ein Bolometer mit einer organischen Halbleiterdiodenschichtanordnung zur Messung der Temperatur, wobei die organische Halbleiterdiodenschichtanordnung eine Schichtfolge aus einer ersten Kontaktschicht (170), einer p-leitenden organischen Halbleiterschicht (190), einer n-leitenden organischen Halbleiterschicht (180) sowie einer zweiten Kontaktschicht (160) aufweist, wobei die zweite Kontaktschicht mit einem ersten Abstandshalter (130b) und die erste Kontaktschicht mit einem zweiten Abstandshalter (130a) verbunden ist, wobei die beiden Abstandshalter (130) die organische Halbleiterdiodenschichtanordnung schwebend über einem Substrat (110) tragen und leitfähig sind, um eine elektrische Verbindung zu einer in dem Substrat befindlichen integrierten Schaltung herzustellen, und wobei die organischen Halbleiterschichten (180, 190) von beiden Abstandhaltern (130) isoliert sind.

2. Bolometer gemäß Anspruch 1, das ferner eine Reflexionsschicht aufweist, die zur Halbleiterdiodenschichtanordnung in einem vorbestimmten Abstand angeordnet ist.

3. Bolometer gemäß Anspruch 1 oder 2, wobei der vorbestimmte Abstand gleich einem Viertel einer Infrarotwellenlänge ist.

4. Bolometer gemäß Anspruch 1 oder 2, wobei die organische Halbleiterdiodenschichtanordnung absorbierend ist für eine Wellenlänge elektromagnetischer Strahlung, und der vorbestimmte Abstand einem Viertel dieser Wellenlänge ist.

5. Bolometer gemäß einem der Ansprüche 1 bis 4, wobei die Halbleiterdiodenschichtanordnung durch Abstandshalter (130) schwebend über einem Substrat (110) aufgehängt ist.

6. Bolometer gemäß einem der Ansprüche 1 bis 5, wobei die organische Halbleiterdiodenschichtanordnung eine Nitridschicht (150) aufweist.

7. Bolometer gemäß einem der Ansprüche 1 bis 6, wobei die organische Halbleiterdiodenschichtanordnung dotiertes organisches Halbleitermaterial aufweist.

**8.** Bolometer gemäß einem der Ansprüche 1 bis 7, wobei die organische Halbleiterdiodenschichtanordnung eine Pt-Black-Schicht aufweist.

**9.** Bolometer gemäß einem der Ansprüche 1 bis 8, wobei die organische Halbleiterdiodenschichtanordnung eine Schichtfolge aus n-dotierter Elektronentransportschicht (260), Löchersperrschicht (250), Emissionsschicht (240), Elektronensperrschicht (230) sowie einer p-dotierten Löchertransportschicht (220) aufweist.

**10.** Bolometer gemäß Anspruch 1, wobei die erste und/ oder die zweite Kontaktschicht derart an die p- bzw. n-leitende organische Halbleiterschicht anliegt, dass die p- bzw. n-leitende organische Halbleiterschicht ganzflächig oder nur in Bahnen kontaktiert ist.

**Claims**

**1.** A bolometer with an organic semiconductor diode layer assembly for temperature measurement, the organic semiconductor diode layer assembly comprising a layer sequence of a first contact layer (170), a p-conducting organic semiconductor layer (190), an n-conducting organic semiconductor layer (180) as well as a second contact layer (160), wherein the second contact layer is connected to a first spacer (130b) and the first contact layer is connected to a second spacer (130a), the two spacers (130) supporting the organic semiconductor diode layer assembly above a substrate (110) in a floating manner and being conductive in order to establish an electrical connection to an integrated circuit located within the substrate, and the organic semiconductor layers (180, 190) being insulated from both spacers (130).

**2.** Bolometer of claim 1, further comprising a reflective layer arranged at a given distance with respect to the semiconductor diode layer assembly.

**3.** Bolometer of claim 1 or 2, wherein the given distance is equal to a quarter of an infrared wavelength.

**4.** Bolometer of claim 1 or 2, wherein the organic semiconductor diode layer assembly is absorbent of a wavelength of electromagnetic radiation and the given distance is equal to a quarter of this wavelength.

**5.** Bolometer of any one of claims 1 to 4, wherein the semiconductor diode layer assembly is suspended above a substrate (110) in a floating manner by means of spacers (130).

**6.** Bolometer of any one of claims 1 to 5, wherein the organic semiconductor diode layer assembly comprises a nitride layer (150).

**7.** Bolometer of any one of claims 1 to 6, wherein the organic semiconductor diode layer assembly comprises doped organic semiconductor material.

**8.** Bolometer of any one of claims 1 to 7, wherein the organic semiconductor diode layer assembly comprises a Pt black layer.

**9.** Bolometer of any one of claims 1 to 8, wherein the organic semiconductor diode layer assembly comprises a layer sequence of an n-doped electron transport layer (260), a hole barrier layer (250), an emission layer (240), an electron barrier layer (230) as well as a p-doped hole transport layer (220).

**10.** Bolometer of claim 1, wherein the first and/or the second contact layer bears on the p- and/or n-conducting organic semiconductor layer such that the p- and/or n-conducting organic semiconductor layer is contacted in a full-area manner or in tracks only.

**Revendications**

**1.** Bolomètre avec un agencement à couche de semi-conducteur organique pour la mesure de température, agencement à couche de semi-conducteur organique présentant une succession de couches composée d'une première couche de contact (170), d'une couche de semi-conducteur organique conductrice p (190), d'une couche de semi-conducteur organique conductrice n (180) ainsi qu'une deuxième couche de contact (160), la deuxième couche de contact étant reliée avec un premier séparateur (130b) et la première couche de contact étant reliée avec un deuxième séparateur (130a), les deux séparateurs (130) portant l'agencement à couche de semi-conducteur organique de manière flottante au-dessus d'un substrat (110) et étant conducteurs, pour établir une connexion électrique avec un circuit intégré se trouvant dans le substrat, et les couches de semi-conducteur organique (180, 190) étant isolées des deux séparateurs (130).

**2.** Bolomètre selon la revendication 1, présentant par ailleurs une couche de réflexion qui est disposée à une distance prédéterminée de l'agencement à couche de semi-conducteur.

**3.** Bolomètre selon la revendication 1 ou 2, la distance prédéterminée étant égale à un quart d'une longueur d'onde infrarouge.

**4.** Bolomètre selon la revendication 1 ou 2, l'agencement à couche de semi-conducteur organique étant absorbante pour une longueur d'onde de radiation électromagnétique, et la distance prédéterminée étant un quart de cette longueur d'onde.

5. Bolomètre selon l'une des revendications 1 à 4, l'agencement à couche de semi-conducteur étant suspendu par des séparateurs (130) de manière flottante au-dessus d'un substrat (110).

6. Bolomètre selon l'une des revendications 1 à 5, l'agencement à couche de semi-conducteur organique présentant une couche de nitrure (150).

7. Bolomètre selon l'une des revendications 1 à 6, l'agencement à couche de semi-conducteur organique présentant un matériau semi-conducteur organique dopé.

8. Bolomètre selon l'une des revendications 1 à 7, l'agencement à couche de semi-conducteur organique présentant une couche de Pt-Black.

9. Bolomètre selon l'une des revendications 1 à 8, l'agencement à couche de semi-conducteur organique présentant une succession de couches composée d'une couche de transport d'électrons dopée n (260), d'une couche de blocage de trous (250), d'une couche d'émission (240), d'une couche de blocage d'électrons (230) ainsi que d'une couche de transport de trous dopée p (220).

10. Bolomètre selon la revendication 1, la première et/ou la deuxième couche de contact s'appuyant sur la couche de semi-conducteur organique conductrice p ou n de sorte que la couche de semi-conducteur organique conductrice p ou n soit interconnectée sur toute la surface ou uniquement par chemins.

# FIG 1

# FIG 2

```
┌──────────────────────────────┐
│▓▓▓▓▓▓▓▓▓▓▓▓▓▓▓▓▓▓▓▓▓▓▓▓▓▓▓▓▓▓│ ~270
├──────────────────────────────┤
│                              │ ~260
├──────────────────────────────┤
│                              │ ~250
├──────────────────────────────┤
│                              │ ~240
├──────────────────────────────┤
│                              │ ~230
├──────────────────────────────┤
│                              │ ~220
├──────────────────────────────┤
│▓▓▓▓▓▓▓▓▓▓▓▓▓▓▓▓▓▓▓▓▓▓▓▓▓▓▓▓▓▓│ ~210
└──────────────────────────────┘
```

# FIG 3

820

850

860

Thermometer

810

830

840

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6812638 B2

### In der Beschreibung aufgeführte Nicht-Patentliteratur

- **T. Ishikawa.** Performance of 320 x 320 Uncooled IRFPA with SOI Diode Detectors. *Proc. SPIE,* vol. 4130, 152-159
- **P. Neuzil ; Y. Liu ; H.-F. Feng ; W. Zeng.** Micromachined Bolometer with Single-Crystal Silicon Diode as Temperature Sensor. *IEEE Electron.Dev.Letters,* Mai 2005, vol. 26 (5), 320-322
- **J.-J.Brissot ; F. Desvignes ; R. Martres.** Organic Semiconductor Bolometric Target for Infrared Imaging Tubes. *IEEE Trans. Electron. Dev.,* Juli 1973, vol. 20 (7), 613-620
- **D. Gebeyehu ; K. Walzer ; G. He ; M. Pfeiffer ; K. Leo ; J. Brandt ; A. Gerhardt ; H. Vestweber.** Highly efficient deep-blue organic light emitting diodes with dopsed transport layers. *Synthetic Metals,* 2005, vol. 148 (2), 205-211
- Organic Light Emitting Diodes. **M. Pfeiffer ; S. R. Forrest.** Nanoelectronics and Information Technology, Advanced Electronic Materials and Novel Devices. Wiley VCH, 2003
- **T. Kawase.** All-Polymer Thin Film Transistors Fabricated by High-Resolution Inkjet Printing. *Proc. IEDM,* 2000, 623-626
- **P. Wellmann.** High-efficiency p-i-n organic light-emitting diodes with long lifetime. *Journal of the SID,* 2005, vol. 13/5, 393-397
- **M. Pfeiffer.** Doped organic semiconductors: Physics and application in light emitting diodes. *Organic Electronics,* 2003, vol. 4, 89-103